(19) Europäisches Patentamt
European Patent Office
Office européen des brevets

(11) **EP 4 645 672 A1**

(12) **EUROPEAN PATENT APPLICATION**

(43) Date of publication:
**05.11.2025 Bulletin 2025/45**

(21) Application number: **25173572.6**

(22) Date of filing: **30.04.2025**

(51) International Patent Classification (IPC):
*H02N 2/02* (2006.01)     *H10N 30/073* (2023.01)
*H10N 30/853* (2023.01)     *G02B 7/00* (2021.01)
*G03B 3/10* (2021.01)

(52) Cooperative Patent Classification (CPC):
**H10N 30/8536; G02B 7/005; G03B 3/10;
H02N 2/0015; H02N 2/0065; H02N 2/026;
H10N 30/045; H10N 30/073; G03B 2205/0061**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **01.05.2024 JP 2024074503
17.03.2025 JP 2025042124**

(71) Applicant: **CANON KABUSHIKI KAISHA
Tokyo 146-8501 (JP)**

(72) Inventors:
• **KAMIOKA, Daiki**
  **Tokyo, 146-8501 (JP)**
• **UEBAYASHI, Akira**
  **Tokyo, 146-8501 (JP)**
• **WATANABE, Takayuki**
  **Tokyo, 146-8501 (JP)**

(74) Representative: **TBK
Bavariaring 4-6
80336 München (DE)**

(54) **VIBRATION-TYPE ACTUATOR, MANUFACTURING METHOD OF VIBRATION-TYPE ACTUATOR, ELECTRONIC DEVICE, AND OPTICAL DEVICE**

(57)     A vibration-type actuator in which the content of lead included in a piezoelectric material is 1000 ppm or less has an elastic body that includes a protruding portion and a flat portion. The protruding portion includes a top portion that contacts a contact body. The protruding portion is provided with a space portion therein, and includes an outer surface and an inner surface. The top portion is arranged at a position crossing a nodal line of out-of-plane vibration of the elastic body in plan view. A value obtained by dividing a total area of a portion surrounded by the outer surface when a base portion of the protruding portion is viewed in cross-section in a direction parallel to the flat portion by a product of a length of a short side and a length of a long side of a principal surface of the piezoelectric element is smaller than 0.178.

FIG. 3

EP 4 645 672 A1

**Description**

BACKGROUND

Technical Field

The present disclosure relates to a vibration-type actuator, a manufacturing method of a vibration-type actuator, an electronic device including a vibration-type actuator, and an optical device.

Description of the Related Art

A vibration-type actuator includes a vibration body configured such that, when an alternating voltage is applied to an electro-mechanical energy conversion element such as a piezoelectric element, a vibration is excited in an elastic body joined to the piezoelectric element. The vibration-type actuator is utilized as an ultrasonic motor that utilizes a driving force of vibration excited in the vibration body, so as to relatively move a contact body that is brought into pressure contact with the vibration body, and the vibration body.

Generally, lead zirconate titanate (PZT) based materials are used as piezoelectric ceramics used for the vibration body. Since these materials contain a large amount of lead in the A site of the $ABO_3$-type perovskite metal oxide, an impact on an environment has been a disadvantage. In order to cope with this disadvantage, piezoelectric ceramics using perovskite-type metal oxides that do not contain lead (whose lead content is less than 1000 ppm) have been proposed.

Japanese Patent Application Laid-Open No. 2017-184233 discloses a manufacturing method of a vibrator using lead-free piezoelectric ceramics.

This manufacturing method discloses a step of bonding an elastic body (written as a vibration plate in the literature) and a power supply member to a piezoelectric element, and thereafter heating piezoelectric ceramics to perform polarization treatment.

Japanese Patent Application Laid-Open No. 2011-200051 discloses a vibration-type actuator that uses an elastic body including a protruding portion with spring properties, and a manufacturing method of the vibration-type actuator. Furthermore, Japanese Patent Application Laid-Open No. 2011-200051 discloses that a space portion is formed between the protruding portion of the elastic body and a piezoelectric element (written as an electro-mechanical energy conversion element in the literature).

However, when the polarization step described in Japanese Patent Application Laid-Open No. 2017-184233 is used in the vibration-type actuator that uses the elastic body and a piezoelectric ceramics that does not contain lead, temperature distribution occurs within the plane of the piezoelectric element, and in-plane distribution of the piezoelectric properties is caused. As a result, it is a disadvantage that vibration characteristics of the vibration-type actuator in a forward direction and a reverse direction are inequivalent.

SUMMARY

Therefore, it is an aspect of the present disclosure to provide a vibration-type actuator having a smaller round-trip speed difference, when the value obtained by dividing the difference between a maximum speed in a forward direction and the maximum speed in the reverse direction by the maximum speed in the forward direction is the round-trip speed difference.

An aspect of the present disclosure is a vibration-type actuator including: a vibration body that includes a rectangular-shaped elastic body and a piezoelectric element including a piezoelectric material; and a contact body that contacts the elastic body, the vibration body and the contact body being relatively moved by vibration of the vibration body, in which a content of lead included in the piezoelectric material is 1000 ppm or less, the elastic body includes at least one protruding portion and a flat portion, the at least one protruding portion including a top portion that contacts the contact body, the at least one protruding portion is provided with a space portion therein, and includes an outer surface and an inner surface, the top portion is arranged at a position crossing a nodal line of out-of-plane vibration of the elastic body in plan view, and a value obtained by dividing a total area of a portion surrounded by the outer surface when a base portion of the at least one protruding portion is viewed in cross section in a direction parallel to the flat portion by a product of a length of a short side and a length of a long side of a principal surface of the piezoelectric element is smaller than 0.178.

In addition, an aspect of the present disclosure is a manufacturing method of a vibration-type actuator including a vibration body with high vibration symmetry, the manufacturing method including: providing electrodes to a piezoelectric material that has not been subjected to polarization treatment to obtain a piezoelectric element; bonding the piezoelectric element and an elastic body at a temperature T1; bonding the piezoelectric element and a power supply member at a temperature T2; performing polarization treatment on the piezoelectric material at a temperature T3 to produce a vibration body; and bringing the vibration body into pressure contact with a contact body, in this order, in which the elastic body includes a protruding portion and a flat portion, the protruding portion including a top portion, the protruding portion is provided with a space portion therein, and includes an outer surface and an inner surface, a value obtained by dividing a total area of a portion surrounded by the outer surface when a base portion of the protruding portion is viewed in cross section in a direction parallel to the flat portion by a product of a length of a short side and a length of a long side of a principal surface of the piezoelectric element is smaller than 0.178, and the T1, the T2 and the T3 satisfy relationships T1 > T3 and T2 > T3.

In addition, an aspect of the present disclosure is a housing and an electronic device including the above-described vibration-type actuator.

In addition, an aspect of the present disclosure is an optical device including an optical element or an imaging element, a housing, and the above-described vibration-type actuator.

Further features of the present disclosure will become apparent from the following description of exemplary embodiments with reference to the attached drawings.

BRIEF DESCRIPTION OF THE DRAWINGS

FIG. 1A is a perspective view for describing the schematic structure of a vibration-type actuator of the present disclosure using a rectangular piezoelectric material.

FIG. 1B is a cross-sectional view taken along a center line (not illustrated) along the lengthwise direction of FIG. 1A in a case where a contact body 104 is added to FIG. 1A.

FIG. 1C is a rear view for describing the schematic structure of the vibration-type actuator of the present disclosure using the rectangular piezoelectric material.

FIG. 2A is a diagram for describing Mode A of two vibration modes generated by a vibration body of the present disclosure including the rectangular piezoelectric material.

FIG. 2B is a diagram for describing Mode B of the two vibration modes generated by the vibration body of the present disclosure including the rectangular piezoelectric material.

FIG. 3 is a diagram for describing the vibration body in polarizing processing of the present disclosure.

FIG. 4A is an example of a diagram (plan view) for describing the positions of nodes and an antinode of the two vibration modes generated in the vibration body of the present disclosure.

FIG. 4B is another example of a diagram (plan view) for describing the positions of the nodes and the antinode of the two vibration modes generated in the vibration body of the present disclosure.

FIG. 5 is a graph illustrating an example of vibration of Mode B generated by the vibration body of the present disclosure measured by a laser doppler vibrometer.

FIG. 6A is an exploded perspective view for describing the structure of the vibration body of the present disclosure, and illustrating the external appearance of the vibration body and the contact body.

FIG. 6B is a cross-sectional view of a periphery of a protruding portion taken along line AA in FIG. 6A, in a case where the vibration body and the contact body come into contact with each other.

FIG. 6C is a cross-sectional view of a base portion of the protruding portion in FIG. 6A cut in a direction parallel to a flat portion.

FIG. 7 is a diagram for describing a schematic structure of an optical device of the present disclosure.

DESCRIPTION OF THE EMBODIMENTS

Preferred embodiments of the present disclosure will now be described in detail in accordance with the accompanying drawings.

<First Embodiment>

First embodiment relates to a vibration-type actuator.
A vibration-type actuator of the present disclosure includes:

a vibration body that includes a rectangular-shaped elastic body and a piezoelectric element including a piezoelectric material; and
a contact body that contacts the elastic body,
the vibration body and the contact body being relatively moved by vibration of the vibration body,
in which a content of lead included in the piezoelectric material is 1000 ppm or less,
the elastic body includes at least one protruding portion and a flat portion, the at least one protruding portion including a top portion that contacts the contact body,

the at least one protruding portion is provided with a space portion therein, and includes an outer surface and an inner surface,

the top portion is arranged at a position crossing a nodal line of out-of-plane vibration of the elastic body in plan view, and

a value obtained by dividing a total area of a portion surrounded by the outer surface when a base portion of the at least one protruding portion is viewed in cross section in a direction parallel to the flat portion by a product of a length of a short side and a length of a long side of a principal surface of the piezoelectric element is smaller than 0.178.

Hereinafter, modes for carrying out the present disclosure will be described.

(Vibration-type Actuator)

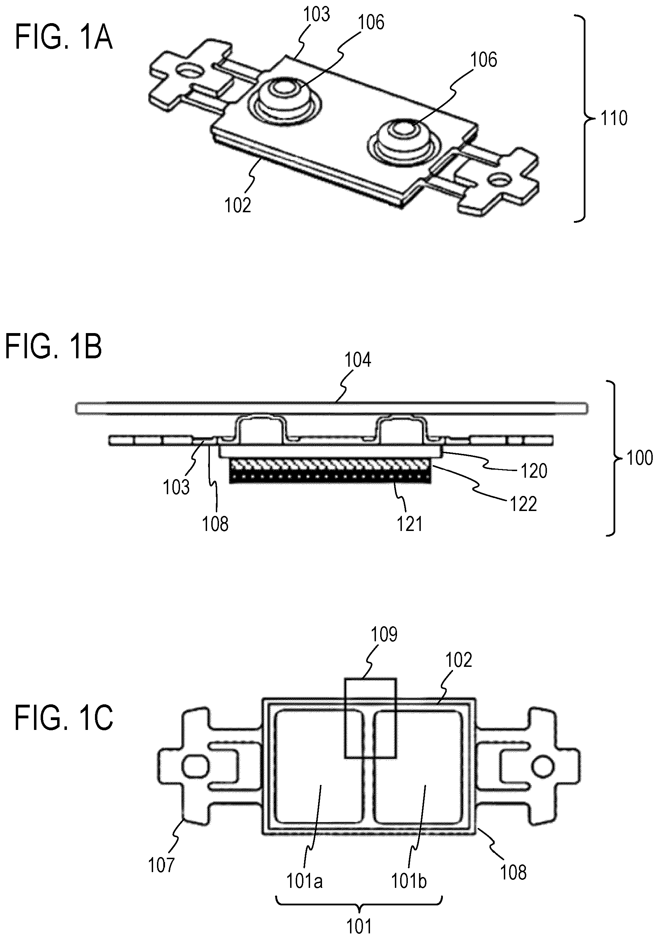

The vibration-type actuator of the present disclosure includes a vibration body that includes a rectangular-shaped elastic body and a piezoelectric element including a piezoelectric material, and a contact body that contacts the elastic body, and the vibration body and the contact body are relatively moved by vibration of the vibration body. FIG. 1A to FIG. 1C illustrate the schematic structure of the vibration-type actuator of the present disclosure. A rectangular-shaped piezoelectric material is used in the vibration-type actuator illustrated in FIG. 1A to FIG. 1C.

A vibration-type actuator 100 includes an electro-mechanical energy conversion element 120 including an electrode 101 and a piezoelectric material 102. Furthermore, in the vibration-type actuator of the present disclosure, an elastic body 103 includes two protruding portions 106 each including a top portion that contacts a contact body 104, and a flat portion 108.

A vibration body 110 includes the elastic body 103 including the flat portion 108 and the protruding portions 106 protruding in the same direction outside a surface of the flat portion, and these are arranged in order. The vibration-type actuator 100 further includes the contact body 104 that contacts the protruding portions 106.

In addition, the vibration-type actuator 100 is provided with a pressurizing member 121 for bringing the vibration body 110 into pressure contact with the contact body 104, and a foamed member 122 between the vibration body 110 and the pressurizing member 121. The contact body 104 may be a member relatively movable with respect to the vibration body 110, is not limited to a member directly contacting the vibration body 110, and may be a member indirectly contacting the vibration body 110 via another member.

A surface of the electro-mechanical energy conversion element 120 is pressurized by the pressurizing member 121 via the foamed member 122. Although means for pressurizing is not limited, a compression spring or a tension spring can be used, since the pressurizing force can be easily adjusted.

(Two Out-of-Plane Bending Vibration Modes)

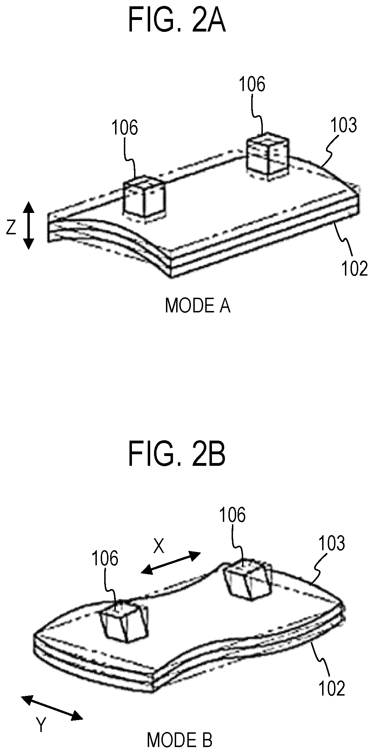

FIG. 2A and FIG. 2B describe two vibration modes generated by the vibration body of the present disclosure including the rectangular piezoelectric material. Regions provided with a first electrode and a second electrode are called a first region and a second region, respectively.

- Mode A

When both the first region and the second region expand or contract, a first bending vibration mode (Mode A) is generated. Mode A is most strongly excited when the phase difference between alternating voltages $V_A$ and $V_B$ applied to a first electrode 101a and a second electrode 101b is 0 degree, and the frequency is near the resonant frequency of Mode A.

Mode A is a first-order out-of-plane vibration mode in which two nodes (where the amplitude becomes minimum) appear substantially parallel to a long side of the vibration body 110. The protruding portions 106 of the elastic body are arranged in a vicinity of the positions of antinodes (where the amplitude becomes maximum) of Mode A. Therefore, leading end surfaces of the protruding portions 106 reciprocate in a Z direction in Mode A.

- Mode B

In a case where the first region expands/contracts, when the second region contracts/expands, a second bending vibration mode (Mode B) is generated. Mode B is most strongly excited when the phase difference between the alternating voltages $V_A$ and $V_B$ applied to the first electrode 101a and the second electrode 101b is 180 degrees, and the frequency is near the resonant frequency of Mode B.

Mode B is a second-order out-of-plane vibration mode in which three nodes appear substantially parallel to a short side of the vibration body 110. The protruding portions 106 of the elastic body are arranged at positions that become nodes in Mode B. Therefore, leading end surfaces of the protruding portions 106 reciprocate in an X direction in Mode B.

In the vibration-type actuator 100 including a rectangular piezoelectric element, when a phase difference between the alternating voltages $V_A$ and $V_B$ is 0 to $\pm180$ degrees, Mode A and Mode B are excited at the same time, and an elliptic vibration is excited in the protruding portions 106 of the elastic body.

(Antinode and Node of Vibration)

In the vibration-type actuator of the present disclosure, the top portion is arranged at a position crossing a nodal line of out-of-plane vibration of the elastic body in plan view. A vibrating piezoelectric element has antinodes of vibration and nodes of vibration, according to the vibration mode.

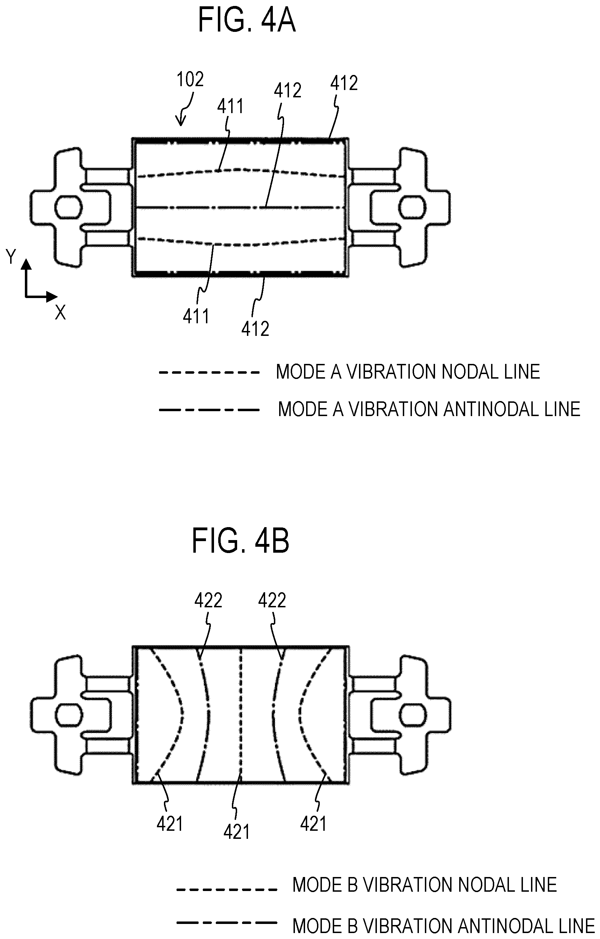

FIG. 4A and FIG. 4B illustrate the positions of nodal lines and antinodal lines of vibration corresponding to Mode A and Mode B generated in the vibration body of the present disclosure. FIG. 4A and FIG. 4B are plan views of the vibration body 110 viewed from the piezoelectric material 102 side.

FIG. 4A illustrates two nodal lines of vibration with dashed lines 411, and three antinodal lines of vibration with one-dot-chain lines 412 in Mode A. Each of nodal lines and antinodal lines in Mode A can be obtained by connecting positions of the nodal lines and antinodal lines of vibration in an arbitrary YZ surface in the X direction.

In addition, FIG. 4B illustrates three nodal lines of vibration with broken lines 421, and two antinodal lines of vibration with one-dot-chain lines 422 in Mode B. Each of the nodal lines and antinodal lines in Mode B can be obtained by connecting the positions of the nodal lines and antinodal lines of vibration in an arbitrary XZ surface in a Y direction. When utilizing the vibration-type actuator 100, both Mode A and Mode B of the vibration body 110 are used.

Nodal line positions and antinodal line positions of vibration generated in the piezoelectric material 102 by excitation in Mode A and Mode B in the vibration body 110 are measured as follows. That is, vibration of Mode A or Mode B is generated in the vibration body 110. When generating Mode A, the phase difference between the alternating voltages $V_A$ and $V_B$ is set to 0 degrees. When generating Mode B, the phase difference between the alternating voltages $V_A$ and $V_B$ is set to 180 degrees.

Then, by measuring the vibration velocity in the Z direction in two dimensions on an XY plane with, for example, a laser doppler vibrometer, and calculating displacement in the Z direction of each point, the positions of nodal lines and antinodal lines in Mode A and Mode B can be measured.

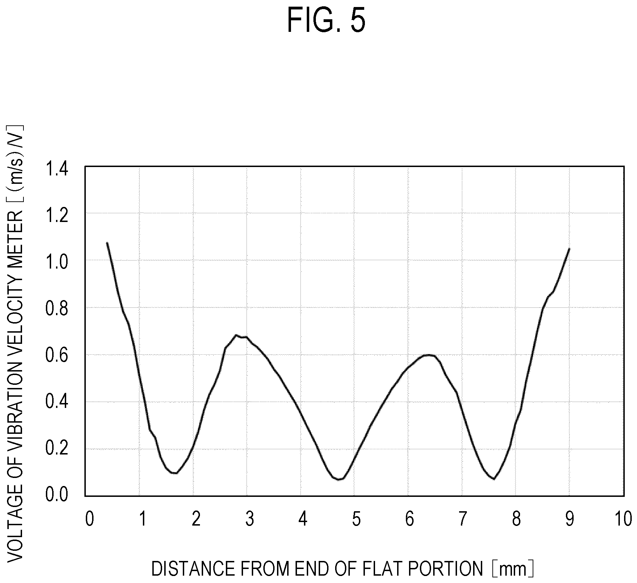

FIG. 5 illustrates data obtained by performing excitation in Mode B, scanning in a longitudinal direction in a center portion of a rectangular portion in a crosswise direction, and measurement of an amplitude in the Z direction. Three nodes of vibration at which an amplitude becomes minimum in the rectangular portion can be seen.

(Material of Elastic Body)

The elastic body 103 can be made of a metal from a viewpoint of property and processability as an elastic body. Examples of metals that can be used for the elastic body 103 include aluminum, brass, and stainless steel. In the vibration-type actuator of the present disclosure, the elastic body can be martensitic stainless steel. Furthermore, vacuum hardened SUS420J2 has high hardness, and is suitable for the vibration-type actuator of the present disclosure in which the contact body is driven by friction with the elastic body.

The elastic body 103 includes the two protruding portions 106 that contact the contact body 104. In order to further improve the wear resistance of the protruding portions, hardening, plating or nitriding is performed on the elastic body. A thickness of the elastic body bonded to the piezoelectric element can be in a range of 0.20 to 0.35 mm, since both rigidity and springiness are obtained, and molding is easy.

(Piezoelectric Element)

The piezoelectric element includes a piezoelectric material and electrodes.

(Piezoelectric Material)

A shape of the piezoelectric material 102 can be a rectangular shape. The vibration-type actuator of the present disclosure includes a rectangular-shaped elastic body, which is preferable since a vibration body with good electric-mechanical energy conversion efficiency can be manufactured when the piezoelectric material has a rectangular shape.

The piezoelectric element is processed so that the thickness becomes a designed value within a range of approximately 0.20 to 0.50 mm. By reducing the thickness of the piezoelectric element, since a neutral plane of distortion is shifted toward the elastic body, a vibration body with good electric-mechanical energy conversion efficiency can be manufactured. On the other hand, when a thickness of the piezoelectric element is reduced, since a stress when deformation increases in proportion to the minus square of the thickness, the piezoelectric element tends to break easily.

Therefore, more preferable thickness is 0.25 to 0.40 mm.

Although a structure of the piezoelectric material 102 is not limited, the piezoelectric material 102 may be, for example, a piezoelectric material (sintered body) without crystal orientation, crystal-oriented ceramics, or piezoelectric single crystals. Although a form that can be taken by the piezoelectric material is not limited, for example, layered piezoelectric materials may be adopted for constituting a laminated body of electrodes and a piezoelectric material, or a single plate of a piezoelectric material may be adopted.

A single plate is excellent from a viewpoint of a cost of piezoelectric material. In order to drive a vibration-type actuator, polarization treatment is performed on a piezoelectric material. When AC electric field frequency applied to the piezoelectric material subjected to a polarization treatment approaches a resonant frequency of the piezoelectric material, the piezoelectric material vibrates greatly due to the resonance phenomenon.

(Composition of Piezoelectric Material)

In the actuator of the present disclosure, a content of lead included in the piezoelectric material is 1000 ppm or less. Accordingly, the actuator of the present disclosure has a small environmental impact.

Generally, lead zirconate titanate ($Pb(Zr,Ti)O_3$) containing lead is widely used for piezoelectric devices. Therefore, a possibility has been pointed out that lead components in conventional piezoelectric materials dissolve into a soil and cause damage to the ecosystem when, for example, piezoelectric elements are discarded and exposed to acid rain, or are left in a harsh environment. The lead content can be measured by, for example, ICP optical emission spectroscopy.

In the vibration-type actuator of the present disclosure, the piezoelectric material can include a barium titanate-based material. A main component of the piezoelectric material can be barium titanate. The piezoelectric material can be a barium titanate-based material from a viewpoint of high piezoelectric constant and relatively easy manufacturing.

Here, examples of barium titanate-based materials include barium titanate ($BaTiO_3$), barium calcium titanate (($Ba,Ca)TiO_3$), barium zirconate titanate ($Ba(Ti,Zr)O_3$), and barium calcium titanate zirconate (($Ba,Ca)(Ti,Zr)O_3$).

In addition, compositions such as sodium niobate-barium titanate ($NaNbO_3$-$BaTiO_3$), bismuth sodium titanate - barium titanate, and bismuth potassium titanate - barium titanate can be included. Furthermore, materials having these compositions as main components can also be included.

Especially, from a viewpoint that both piezoelectric constant and mechanical quality factor of a piezoelectric material can be achieved, the following materials can be used. That is, barium calcium titanate zirconate (($Ba,Ca)(Ti,Zr)O_3$) and sodium niobate-barium titanate (($1-x)NaNbO_3 - xBaTiO_3$, x = 0. 1 to 0. 15) can be included as main components. Manganese and bismuth can be included as elements other than the main components. The main components refers to a material whose mass fraction is greater than 10%.

In the vibration-type actuator of the present disclosure, the piezoelectric material can include barium calcium titanate zirconate. The main component of the piezoelectric material can be barium calcium titanate zirconate (hereinafter also referred to as BCTZ). When BCTZ is the main component, piezoelectricity of BCTZ can be adjusted according to applications by adjusting amounts of Ca and Zr. In addition, the amount expensive niobium to be used can be reduced.

In the vibration-type actuator of the present disclosure, the piezoelectric material can be a piezoelectric material containing an oxide and Mn, the oxide having a perovskite-type structure including Ba, Ca, Ti and Zr,

x, which is a ratio of a molar amount of the Ca to sum of a molar amount of the Ba and the molar amount of the Ca, is $0.02 \leq x \leq 0.30$,
y, which is a ratio of a molar amount of the Zr to sum of a molar amount of the Ti and the molar amount of the Zr, is $0.020 \leq y \leq 0.095$ and $y \leq x$,
$\alpha$, which is a ratio of sum of a molar amount of the Ba and a molar amount of the Ca to sum of a molar amount of the Ti and a molar amount of the Zr, is $0.9955 \leq \alpha \leq 1.01$, and
a content of the Mn with respect to 100 parts by mass of the oxide can be 0.02 parts by mass or more and 1.0 parts by mass or less in terms of metal.

Such a piezoelectric material can be represented by the following general formula (1).

$$(Ba_{1-x}Ca_x)_\alpha(Ti_{1-y}Zr_y)O_3 \qquad (1)$$

However, a perovskite metal oxide represented by

$$0.9955 \leq \alpha \leq 1.01,$$

$$0.02 \leq x \leq 0.30,$$

and

$$0.020 \leq y \leq 0.095$$

can be a main component, and a content of metal components other than the main component included in the piezoelectric material can be 1 part by mass or less in terms of metal per 100 parts by mass of the metal oxide.

In particular, Mn can be contained in the metal oxide, and the content of the Mn can be 0.02 parts by mass or more and 0.40 parts by mass or less in terms of metal with respect to 100 parts by mass of the metal oxide. When Mn is contained in the aforementioned range, insulation properties and mechanical quality factor Qm are improved.

Here, the mechanical quality factor Qm is a coefficient that represents an elastic loss due to vibration when evaluating a piezoelectric material as a vibration body, and a magnitude of the mechanical quality factor is observed as a sharpness of a resonance curve in impedance measurement. That is, the mechanical quality factor Qm is a constant that represents the sharpness of resonance of the vibration body. When the mechanical quality factor Qm is large, a distortion amount of the piezoelectric material is increased near the resonant frequency, and the piezoelectric material can be effectively vibrated.

The metal oxide represented by the aforementioned general formula (1) means that the metal elements located at the A site of the perovskite structure are Ba and Ca, and the metal elements located at the B site are Ti and Zr. However, a part of Ba and Ca may be located in the B site. Similarly, a part of Ti and Zr may be located in the A site.

Although the molar ratio of B site elements to O element in the general formula (1) is 1:3, even if the molar ratio is slightly off, when the metal oxide has a perovskite structure as its main phase, the metal oxide is included in the scope of the present disclosure.

Whether the metal oxide has a perovskite structure can be determined by structural analysis using, for example, X-ray diffraction or electron beam diffraction.

x, which indicates the molar ratio of Ca in the A site in the general formula (1), is in a range of $0.02 \leq x \leq 0.30$. When a part of Ba in perovskite-type barium titanate is replaced with Ca within the aforementioned range, a phase transition temperature between orthorhombic and tetragonal shifts to a lower temperature side. Therefore, stable piezoelectric vibration can be obtained in a driving temperature range of vibration-type actuator.

However, when x is larger than 0.30, a piezoelectric constant of the piezoelectric material becomes insufficient, and it is a risk that a performance of the vibration-type actuator becomes insufficient. On the other hand, when x is smaller than 0.02, it is a risk that a dielectric loss (tan $\delta$) is increased. When the dielectric loss is increased, it is a risk that heat generation in applying a voltage to the piezoelectric material to drive the vibration-type actuator is increased, motor drive efficiency is decreased, and power consumption is increased.

In the general formula (1), y, which represents a molar ratio of Zr in the B site, is in a range of $0.02 \leq y \leq 0.30$. When y is larger than 0.30, Td becomes less than 80°C, which is low, and a temperature range in which the vibration-type actuator can be used becomes less than 80°C, which is not preferable.

In this description, Td refers to a lowest temperature among temperatures at which the piezoelectric constant after heating the piezoelectric material from room temperature to Td one week after performing polarization treatment and then cooling the piezoelectric material back to room temperature drops by more than 10% compared to the piezoelectric constant before the heating.

In addition, in the general formula (1), $\alpha$, which is a ratio of a molar amount of Ba and Ca in the A site to a molar amount of Ti and Zr in the B site can be in a range of $0.9955 \leq \alpha \leq 1.01$. When $\alpha$ is smaller than 0.9955, abnormal grain growth is likely to occur in the crystal grains that constitute the piezoelectric material, and the mechanical strength of the piezoelectric material is reduced. On the other hand, when $\alpha$ becomes larger than 1.01, a piezoelectric material does not densify and an insulation properties becomes significantly low.

Means for measuring a composition of the piezoelectric material is not particularly limited. Examples of the means include X-ray fluorescence analysis, ICP optical emission spectroscopy, and atomic absorption spectrometry. Any measuring means can be used to calculate a mass ratio and composition ratio of each element contained in the piezoelectric material.

In the metal conversion indicating a content of Mn, a content of each of metals Ba, Ca, Ti, Zr and Mn measured from the piezoelectric material by X-ray fluorescence analysis (XRF), ICP optical emission spectroscopy, atomic absorption spectrometry, etc. is calculated. From the content, elements constituting the metal oxide represented by the general formula (1) are converted into oxides, and a value obtained from a ratio of mass of Mn to total mass of 100 is represented.

When a content of Mn is less than 0.02 parts by mass, it is a risk that an effect of polarization treatment required for driving of the vibration-type actuator becomes insufficient. On the other hand, when the content of Mn is larger than 0.40 parts by mass, they are risks that the piezoelectric properties of the piezoelectric material become insufficient, and hexagonal crystals that do not have piezoelectric properties emerge.

Mn is not limited to metallic Mn, but may be included in the piezoelectric material as an Mn component, and a form of containment is not important. For example, Mn may be in the B site as a solid solution, or may be included in a grain boundary. A form of a more preferable containment is to be in the B site as a solid solution from a viewpoint of insulation properties and the ease of sintering.

The piezoelectric material can contain 0.042 parts by mass or more and 0.850 parts by mass or less of Bi in terms of metal.

The piezoelectric material may contain 0.85 parts by mass or less of Bi(s) in terms of metal per 100 parts by mass of the metal oxide represented by the general formula (1). A content of Bi in the metal oxide can be measured by, for example, ICP optical emission spectroscopy.

Bi may be in the grain boundary of a ceramics-like piezoelectric material, or may be in a perovskite-type structure of $(Ba,Ca)(Ti,Zr)O_3$ as a solid solution. When Bi exists in the grain boundary, friction between particles is reduced and the mechanical quality factor is increased. On the other hand, when Bi is taken into the solid solution that forms a perovskite structure, since a phase transition temperature is decreased, a temperature dependence of the piezoelectric constant become smaller, and the mechanical quality factor is further improved. A position of Bi when Bi is taken into the solid solution can be in the A site, since charge balance with the Mn becomes better.

The piezoelectric material may include components other than the elements included in the general formula (1) and Mn and Bi (hereinafter, sub-components) to an extent that the characteristics are not varied. A sum of the sub-components can be less than 1.2 parts by mass per 100 parts by mass of the metal oxide represented by the general formula (1).

When the sub-components exceed 1.2 parts by mass, it is a risk that the piezoelectric properties and insulating properties of the piezoelectric material are deteriorated. In the vibration-type actuator of the present disclosure, depolarization temperature Td of the piezoelectric material can be 126°C or less. The Curie temperature of $(Ba,Ca)(Ti,Zr)O_3$ is in a range of 85°C or more and 126°C or less.

(Structure of Piezoelectric Element)

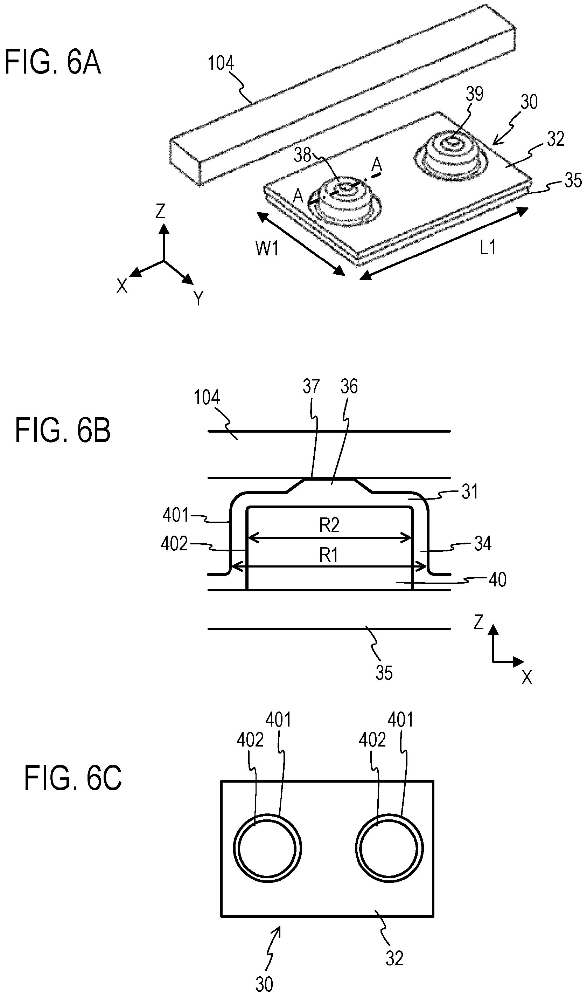

FIG. 6A to FIG. 6C illustrate diagrams for describing a structure of the vibration body of the present disclosure. In the vibration-type actuator of the present disclosure, each of protruding portions 38 and 39 is provided with a space portion 40 therein, and includes an outer surface 401 and an inner surface 402. A vibration body 30 includes the protruding portions 38 and 39 and a flat portion 32, and includes space portions 40 surrounded by wall portions 34 and a piezoelectric element 35. Each of the protruding portions 38 and 39 includes a wall portion 34, a connecting portion 31, and a contact portion 36, and contacts the contact body 104 at a contact surface 37.

In the vibration-type actuator of the present disclosure, a value S2/S1 obtained by dividing a total area S2 (the sum of areas) of portions surrounded by the outer surfaces 401 when base portions of the protruding portions 38 and 39 are viewed in cross section in a direction parallel to the flat portion 32 by a product S1 of a length of a short side and a length of a long side of a principal surface of the piezoelectric element can be smaller than 0.178. In this manner, a temperature distribution becomes uniform, and a uniformity of piezoelectric properties can be ensured.

More preferable S2/S1 is 0.099 or more and 0.156 or less. In this manner, the temperature distribution becomes more uniform, and the uniformity of piezoelectric properties is improved. When a number of protruding portions is one, S2 is the area surrounded by the outer surface 401, and when a number of protruding portions is two or more, sum of such areas is set to S2.

Furthermore, in the vibration-type actuator of the present disclosure, a value S3/S1 obtained by dividing a total area S3 (sum of areas) of portions surrounded by the inner surfaces 402 when base portions of the protruding portions 38 and 39 are viewed in cross section in a direction parallel to the flat portion 32 by a product S1 of length of the short side and length of the long side of a principal surface of the piezoelectric element can be smaller than 0.124. In this manner, the temperature distribution becomes uniform, and the uniformity of piezoelectric properties can be ensured.

More preferable S3/S1 is 0.069 or more and 0.093 or less. In this manner, the temperature distribution becomes more uniform, and the uniformity of piezoelectric properties is improved. When the number of protruding portions is one, S3 is the area surrounded by the inner surface 402, and when the number of protruding portions is two or more, the sum of such areas is set to S3.

FIG. 6A is an exploded perspective view illustrating an external appearance of the vibration body and the contact body, FIG. 6B is a cross-sectional view of the periphery of the protruding portion taken along line AA in FIG. 6A, in a case where a vibration body and the contact body come into contact with each other, and FIG. 6C is a cross-sectional view of a base portion of the protruding portion cut in a direction parallel to the flat portion.

As illustrated in FIG. 6A, FIG. 6B and FIG. 6C, S1, S2 and S3 can be obtained by calculation, by assuming shapes of a perfect circle and a rectangle from W1, L1, R1 and R2. W1, L1 and R1 can be measured with an optical microscope. R2 can be similarly measured with an optical microscope by peeling an interface between a piezoelectric element and the elastic body. In addition, when an ultrasonic flaw detection test is performed, non-destructive shape measurement can be performed.

In the vibration-type actuator of the present disclosure, a top portion is arranged at a position crossing a nodal line of out-of-plane vibration of the elastic body in plan view. In the vibration-type actuator of the present disclosure, the top portions can be arranged to cross the nodal line of out-of-plane vibration of the elastic body, so that a distance between the two protruding portions becomes shortest.

The top portions can be arranged so that a distance between the two protruding portions becomes shortest, since the top portions are in a vicinity of the antinodal lines of out-of-plane-vibration Mode A, and an amplitude in the Z direction becomes maximum. Whether the top portion of the protruding portion 106 crosses the nodal line in Mode B or is in the vicinity of the antinodal line in Mode A can be verified with a laser doppler vibrometer. By measuring the vibration velocity of the top portion of the protruding portion 106 in the Z direction in two dimensions on an XY plane, and calculating displacement in the Z direction of each point, the positions of nodal lines and antinodal lines in Mode A and Mode B can be measured.

In the vibration-type actuator of the present disclosure, the elastic body can include supporting portions 107 that protrude from end portions of the flat portion 108. The vibration body is supported in fitting holes provided in the supporting portions 107. Since the supporting portions 107 are provided, the vibration body can be held by a heating device during polarization treatment, and positional deviation can be suppressed. Accordingly, individual differences in uneven heating can be reduced, leading to improved yields.

FIG. 5 illustrates data obtained by performing excitation in Mode B, scanning in a longitudinal direction in a center portion of a rectangular portion in a crosswise direction, and measurement of an amplitude in the Z direction, and is a graph of a voltage value of a vibration velocity meter versus the distance from an end of a flat portion. The top portions of the protruding portions 106 are arranged at positions crossing two outer nodal lines of the three nodes of vibration at which the amplitude becomes minimum. A position of the nodal line can be in 80% from a center of a diameter of the top portion of protruding portion 106. In this manner, an influence of the piezoelectric properties distribution on the vibration characteristics can be further reduced.

<Second Embodiment>

A second embodiment relates to a manufacturing method of a vibration-type actuator.

A manufacturing method of a vibration-type actuator of the present disclosure is a manufacturing method of a vibration-type actuator including a vibration body with high vibration symmetry, the manufacturing method including:

> providing electrodes to a piezoelectric material that has not been subjected to polarization treatment to obtain a piezoelectric element;
> bonding the piezoelectric element and an elastic body at a temperature T1;
> bonding the piezoelectric element and a power supply member at a temperature T2;
> performing polarization treatment on the piezoelectric material at a temperature T3 to produce a vibration body; and bringing the vibration body into pressure contact with a contact body, in this order, in which the elastic body includes a protruding portion and a flat portion, the protruding portion including a top portion,
> in which the protruding portion is provided with a space portion therein, and includes an outer surface and an inner surface,
> a value obtained by dividing a total area of a portion surrounded by the outer surface when a base portion of the protruding portion is viewed in cross section in a direction parallel to the flat portion by a product of a length of a short side and a length of a long side of a principal surface of the piezoelectric element is smaller than 0.178, and
> the T1, the T2 and the T3 satisfy relationships T1 > T3 and T2 > T3.

Hereinafter, a description will be given with reference to FIG. 1A to FIG. 1C, FIG. 2A, FIG. 2B, and the like. Description of the matters described in the first embodiment may be omitted.

(Obtaining Piezoelectric Element)

The manufacturing method of the vibration-type actuator of the present disclosure is a manufacturing method of a vibration-type actuator including a vibration body with high vibration symmetry, the manufacturing method including providing electrodes to a piezoelectric material that has not been subjected to polarization treatment to obtain a piezoelectric element. When a rectangular-shaped piezoelectric material is used as a piezoelectric material, a rectangular electrode 101 is provided. The electrode 101 includes the first electrode 101a and the second electrode 101b. The first electrode 101a and the second electrode 101b are used for the polarization treatment of the rectangular piezoelectric material, and for driving of the vibration-type actuator that uses the rectangular piezoelectric material.

The electrode 101 is made of a metal film with a thickness of 0.3 to 10 $\mu$m. Although the material is not particularly limited, a silver, gold or platinum electrode is generally used. The manufacturing method of the electrode is not limited, and the electrode can be formed by screen printing, sputtering, vacuum evaporation, etc. In order to produce an electro-mechanical energy conversion element with a lead content of 1000 ppm or less, a paste or target with a lead content of less than 1000 ppm is also required to be used in a formation of the electrode.

(Bonding at Temperature T1)

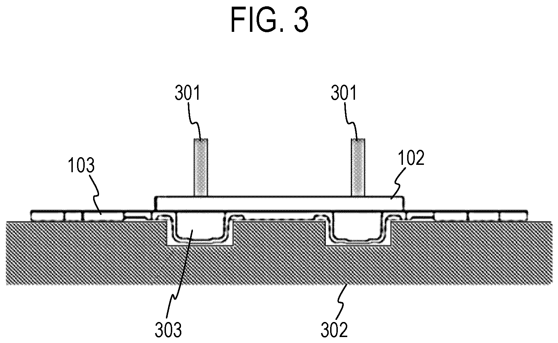

The manufacturing method of the vibration-type actuator of the present disclosure includes bonding the piezoelectric element and the elastic body at the temperature T1. FIG. 3 illustrates a diagram for describing a state of the vibration body in the polarization treatment of the present disclosure. The elastic body 103 can be made of a metal from a viewpoint of property and processability as an elastic body.

Examples of metals that can be used for the elastic body 103 include aluminum, brass, and stainless steel. Among stainless steels, martensitic stainless steel can be used, and vacuum hardened SUS420J2 has high hardness, and is suitable for the vibration-type actuator of the present disclosure in which the contact body is driven by friction with the elastic body. The elastic body 103 includes the two protruding portions 106 that contact the contact body 104. In order to further improve the wear resistance of the protruding portions, hardening, plating or nitriding is performed on the elastic body.

The elastic body 103 is provided on the piezoelectric material 102 via a first adhesion layer. This is for integrating the piezoelectric material 102 and the elastic body 103 to form a traveling wave of bending vibration in out-of-plane direction (hereinafter also referred to as out-of-plane vibration). A first adhesion layer is obtained by curing an adhesive, and epoxy resin is preferably used as the adhesive. The temperature T1 is set to a temperature at which the adhesive is cured in a short time, and the first adhesion layer has sufficient adhesive strength. Specifically, the temperature T1 is 20°C or more, preferably 80°C or more, and more preferably 120°C or more.

Note that the temperature T1 means not an ambient temperature, but a temperature of the piezoelectric material 102, and can be measured by using a thermocouple or a radiation thermometer. Similar to T1, T2, which will be described later, also refers to the temperature of the piezoelectric material 102. The piezoelectric material 102 and the elastic body 103 can be provided so that centers of respective adhesion surfaces coincide with each other. In this manner, the vibration characteristics in the forward direction and the reverse direction become equivalent, and a yield of the piezoelectric vibration body becomes higher.

(Bonding at Temperature T2)

The manufacturing method of the vibration-type actuator of the present disclosure includes bonding the piezoelectric element and the power supply member at the temperature T2. The vibration-type actuator of the present disclosure includes a power supply member 109 joined to the piezoelectric element that includes the piezoelectric material and the electrode. The power supply member 109 is provided on the piezoelectric material 102 via a second adhesion layer.

A flexible printed circuit board (hereinafter also referred to as an FPC) can be used for the power supply member, since dimensional accuracy is high, and positioning is easy. Polyimide can be used as the material. Although joining method of the FPC and the piezoelectric element is not particularly limited, an anisotropic conductive paste (ACP) or anisotropic conductive film (ACF) with highly reliable adhesive tact and electrical connection can be used. By supplying power by the FPC, power can be supplied without inhibiting vibration of the piezoelectric element. The FPC is connected to at least the first electrode and the second electrode, and may be connected to a non-driving phase electrode.

The FPC and the electrode are bonded at the temperature T2. The temperature T2 and the depolarization temperature Td of the piezoelectric material can satisfy the relationship T2 $\geq$ Td. By satisfying this relationship, the piezoelectric constant of the piezoelectric material can be made as close to 0 as possible.

Here, the depolarization temperature Td refers to a temperature at which the piezoelectric constant is decreased compared to the piezoelectric constant before the temperature is increased, when a temperature of the piezoelectric material is increased from room temperature (for example, 20 to 30°C) to a certain temperature and then cooled back to room temperature after a sufficient amount of time elapses since the piezoelectric material is subjected to polarization treatment. In the present disclosure, the temperature at which the piezoelectric constant becomes less than 90% of the piezoelectric constant before the temperature is increased is called the depolarization temperature Td.

The temperature T2 is set to a temperature at which the adhesive is cured in a short time, and a second bonded portion has sufficient adhesive strength. Specifically, the temperature T2 is 20°C or more, preferably 100°C or more, and more preferably 140°C or more. When the temperature T2 is 140°C or more, the second bonded portion can obtain sufficient adhesive strength in about 10 seconds to 30 seconds. In addition, the pressure in forming the second bonded portion by thermocompression can be 1 MPa or more. When the pressure is less than 1 MPa, it is a risk that so-called floating occurs.

The power supply member 109 can be bonded to the regions of two driving phase electrodes with an equivalent area. If an extreme difference in area occurs, when the vibration body 110 is vibrated, a difference occurs between the regions where power supply member 109 inhibits vibration, and as a result, it is a risk that the vibration characteristics in the forward direction and the reverse direction are not equivalent.

(Producing Vibration Body)

The manufacturing method of the vibration-type actuator of the present disclosure includes performing polarization treatment on the piezoelectric material at a temperature T3 to produce a vibration body. Ceramics are generally a collection of minute crystals (also referred to as polycrystals), and each crystal includes positively charged atoms and negatively charged atoms. Many ceramics are in a state where positive and negative charges are balanced.

However, in some dielectric ceramics, which are called ferroelectrics, positive and negative charges in the crystal are not balanced even in a natural state, and the charge becomes biased (spontaneous polarization). In ferroelectric ceramics that have not been subjected to polarization treatment, a direction of this spontaneous polarization is random, and the ceramic as a whole appears to have no bias in the charge.

However, when a high voltage is applied to ferroelectric ceramics that has not been subjected to polarization treatment, an orientation of the spontaneous polarization is aligned in a uniform direction, and does not return to an original direction even when the voltage is removed. Aligning the orientation of the spontaneous polarization in this manner is referred to as polarization treatment.

When the temperature at which polarization treatment is performed on the vibration body used in the present disclosure is T3, the temperature T1 at which the piezoelectric element and the elastic body are bonded, and the temperature T2 at which the piezoelectric element and the power supply member are bonded need to satisfy T1>T3 and T2>T3. In other words, in the manufacturing method of the vibration-type actuator of the present disclosure, T1, T2 and T3 satisfy the relationships T1>T3 and T2>T3.

When the temperature T3 is higher than the temperature T1, a bonded portion provided between the piezoelectric material 102 and the elastic body 103 softens, a center of the adhesion surface of the piezoelectric material 102 is misaligned with a center of the adhesion surface of the elastic body 103, and the vibration characteristics in the forward direction and the reverse direction become inequivalent. On the other hand, when the temperature T3 is higher than the temperature T2, the bonded portion provided between the piezoelectric material 102 and the power supply member 109 may soften, and a center line of the power supply member 109 may be misaligned with a center line of the piezoelectric material 102 in the long side direction.

In this case, the power supply member 109 is not bonded to regions of two driving phase electrodes with an equivalent area, a difference occurs between regions where the power supply member 109 inhibits vibration when the vibration body 110 is vibrated, and as a result, it is a risk that the vibration characteristics in forward direction and reverse direction become inequivalent.

Accordingly, in the manufacturing method of the vibration-type actuator of the present disclosure, T1, T2 and T3 can satisfy the relationship T1>T2>T3. In this manner, equivalent vibration characteristics can be more positively obtained.

In addition, the temperature T3, a glass transition temperature Tg1 of a bonded portion between the piezoelectric element and the elastic body, and a glass transition temperature Tg2 of a bonded portion between the piezoelectric element and the power supply member can satisfy relationships Tg1>T3 and Tg2>T3.

When the temperature T3 is equal to or more than Tg1 and Tg2, each bonded portion is softened once. Then, if the temperature becomes lower than the temperature Tg1 and the temperature Tg2 when completing polarization treatment, each bonded portion is cured again. In this case, it is a risk that a center of an adhesion surface of the piezoelectric material 102 is misaligned with a center of an adhesion surface of the elastic body 103. This is undesirable since it is a risk that vibration characteristics in the forward direction and the reverse direction become equivalent.

Although an electric field strength applied to the vibration body 110 in performing polarization treatment is not particularly limited, the electric field strength can be 0.5 kV/mm to 2.0 kV/mm from a viewpoint of performing polarization treatment for a short time. In addition, the temperature T3 can be 20°C or more. When the temperature T3 is lower than 20°C, a time period until the piezoelectric material reaches a state where the piezoelectric material has a sufficient piezoelectric constant may become long. From a viewpoint of completing polarization treatment in a short time, the temperature T3 can be 100°C or more, more preferably 120°C or more.

FIG. 3 illustrates a diagram for describing the vibration body in polarization treatment of the present disclosure. In the vibration-type actuator of the present disclosure, the protruding portion 106 is provided with a space portion 303 therein, and includes an outer surface and an inner surface, the space portion 303 is formed between the protruding portion 106 and the piezoelectric material 102 joined to the protruding portion 106, and during polarization processing, this space portion 303 prevents the piezoelectric element from being heated (by a heating tool 302), and heating distribution occurs within the plane of the piezoelectric element. As a result, in-plane distribution of polarization treatment occurs, and in-surface distribution of piezoelectric properties occurs.

(Bringing into Pressure Contact)

The manufacturing method of the vibration-type actuator of the present disclosure includes performing polarization treatment on the piezoelectric material at the temperature T3 to produce a vibration body, and bringing the vibration body into pressure contact with a contact body. The contact body 104 can be stainless steel from a viewpoint of rigidity. Among stainless steels, martensitic stainless steel is preferable, and SUS420J2 is the most preferable.

Since the contact body 104 is in frictional contact with the elastic body 103, the contact body 104 need to have excellent wear resistance, and nitriding treatment or alumite treatment are performed on a surface of the contact body 104. A frictional force is generated between the protruding portion 106 and the contact body 104 due to pressure contact. Although means for bringing into pressure contact is not limited, a compression spring or a tension spring can be used, since a pressurizing force can be easily adjusted. A leading end of the protruding portion 106 can be vibrated in an elliptic manner by vibration generated by the piezoelectric material 102 to generate a driving force (thrust) for driving the contact body 104.

The contact body is generally called a slider or a rotor. Note that the "contact body" refers to a member that contacts the vibration body, and that is relatively moved with respect to the vibration body by vibration generated in the vibration body. The contact between the contact body and the vibration body is not limited to direct contact without other member interposed between the contact body and the vibration body.

If the contact body is relatively moved with respect to the vibration body by vibration generated in the vibration body, a contact between the contact body and the vibration body may be indirect contact with other member interposed between the contact body and the vibration body. The "other member" is not limited to a member (for example, a high friction member made of sintered body) that is independent of the contact body and the vibration body. The "other member" may be a surface-treated portion formed on the contact body or the vibration body by plating, nitriding or the like.

<Applications>

Applications relate to an electronic device and an optical device.

(Electronic Device)

An electronic device of the present disclosure includes a housing and the above-described vibration-type actuator. The electronic device of the present disclosure includes the above-described vibration-type actuator, a member connected to the contact body of the vibration-type actuator, and a member position detecting unit (for example, an encoder). The electronic device can precisely control a position of the member by detecting the position of the member, and operating the vibration-type actuator until the member reaches a target position.

(Optical Device)

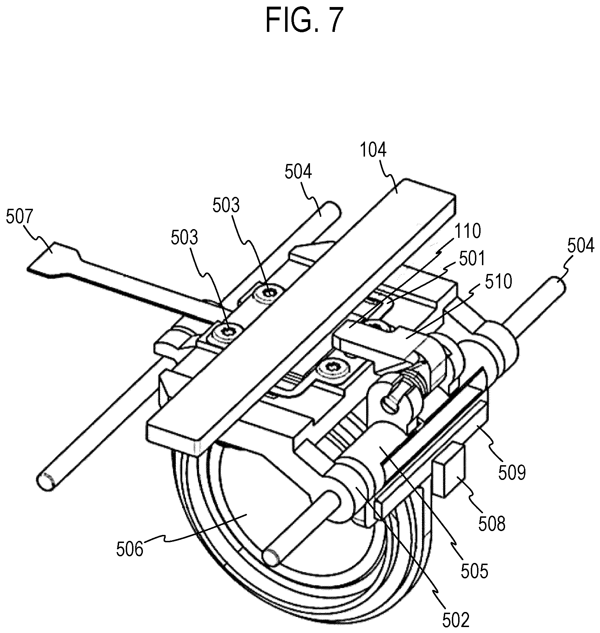

An optical device of the present disclosure includes an optical element or an imaging element, a housing, and the above-described vibration-type actuator. FIG. 7 is a schematic diagram illustrating one embodiment of the optical device (a focus lens unit of a lens barrel device) of the present disclosure.

In FIG. 7, the vibration body 110 including the rectangular piezoelectric material is brought into pressure contact with the contact body (slider) 104 as in FIG. 1B. A power supply member 507 is connected to a surface side having first and second regions. When a desired voltage is applied to the vibration body 110 via the power supply member 507 by a voltage input unit, which is not illustrated, elliptical motion occurs in the protruding portion of the elastic body, which is not illustrated.

A holding member 501 is joined to the vibration body 110, and is configured so as not to generate unnecessary vibration. A mobile housing 502 is fixed to the holding member 501 with screws 503, and is integral with the vibration body 110. The electronic device of the present disclosure is formed by including these members. By attaching the mobile housing 502 to guide members 504, the electronic device of the present disclosure can move linearly in both directions (the forward direction and the reverse direction) along the guide members 504.

Next, a lens 506 (optical member) that serves as a focus lens of a lens barrel device will be described. The lens 506 is fixed to a lens holding member 505, and has an optical axis (not illustrated) parallel to the movement direction of the vibration-type actuator. Similar to the vibration-type actuator, the lens holding member 505 performs focus position adjustment (a focusing operation) by linearly moving on the two guide member 504, which will be described later.

The two guide members 504 are members that causes the mobile housing 502 and the lens holding member 505 to be fitted together, so as to enable linear movement of the mobile housing 502 and the lens holding member 505. With such a configuration, the mobile housing 502 and the lens holding member 505 can linearly move on the guide members 504.

In addition, a coupling member 510 is a member that transmits the driving force generated by the vibration-type actuator to the lens holding member 505, and is fitted and attached to the lens holding member 505. Accordingly, the lens holding member 505 can smoothly move in both directions along the two guide members 504 together with the mobile housing 502.

In addition, a sensor 508 is provided for detecting the position of the lens holding member 505 on the guide member 504, by reading the position information of a scale 509 pasted to a side surface portion of the lens holding member 505. The focus lens unit of the lens barrel device is constituted by incorporating each of the above-described members as described above.

In the above, although the lens barrel device for single-lens reflex cameras has been described as the optical device, it can be applied to various optical devices provided with a vibration-type actuator, regardless of a type of camera, such as a compact camera in which a lens and a camera body are integral, and an electronic still camera.

In addition, as another configuration of the vibration-type actuator, a plurality of vibration bodies may contact one common contact body, and the contact body may be arranged to be relatively moved with respect to the plurality of vibration bodies by vibration of the plurality of vibration bodies.

The vibration-type actuator of the present disclosure can be applied to the vibration body 110 and the contact body 104. As an application example of the vibration-type actuator of the present disclosure, application to a medical or engineering field is conceivable. Specifically, a wire-driven actuator can also be configured that includes an elongated member, a wire inserted into the elongated member and fixed to a part of the elongated member, and the above-described vibration-type actuator driving the wire, in which the elongated member is curved by driving of the wire.

[Examples]

Next, the vibration-type actuator and the vibration body of the present disclosure will be described with reference to examples. However, the present disclosure is not limited by the following examples.

(Example 1)

Metal oxide powder was sintered at 1340°C to obtain a piezoelectric material shown in Manufacturing Composition 1 in Table 3. Manufacturing composition 1 is the composition represented by the general formula (1), and the values of x, y and $\alpha$ shown in Table 3 correspond to the respective values of the general formula (1) described above.

The obtained piezoelectric material was ground and polished to approximately uniform thicknesses of 0.25 mm, 0.30 mm, 0.35 mm, and 0.40 mm, and then processed into a rectangle of 8.7 to 9.1 mm x 5.5 to 5.7 mm. The electrode 101 illustrated in FIG. 1A to FIG. 1C was formed on both surfaces of a shaped piezoelectric material. The electrode was formed by applying a silver paste to the piezoelectric material 102 by screen printing, and drying and baking the silver paste.

Next, an adhesive was applied to an elastic body made of SUS420J2, and the elastic body was crimped to a rectangular piezoelectric material in which the electrode was formed. The used elastic body had a rectangular portion of 9.3 x 5.8 mm, which is larger than the piezoelectric material, and thickness of the elastic body was between 0.25 to 0.30 mm. The rectangular piezoelectric material and the elastic body were arranged by using a positioning jig, so that centers of the respective rectangular portions coincide with each other and sides of respective rectangular portions are parallel. In a crimped condition, the piezoelectric material was heated to a temperature T1 = 160°C and held for 180 seconds, then cooled to room temperature, and a pressure was released to obtain a vibration body.

Next, an FPC on which an ACP was applied and the piezoelectric material were crimped together for 20 seconds by using a soldering iron at a temperature T2 = 140°C, so as to thermocompression bond the FPC to an electrode provided in the piezoelectric material.

Subsequently, polarization treatment was performed on the piezoelectric material. In the polarization treatment, the elastic body was grounded, and a power supply unit 301 connected to a power supply was brought into contact with each of the first electrode and the second electrode. The first electrode and the second electrode were already connected to the FPC, but were not entirely covered by the FPC, and the power supply unit 301 for polarization treatment contacts exposed portions.

Thereafter, after heating to T3 = 100°C, an electric field equivalent to 2.0 kV/mm was applied for 30 minutes. Thereafter, cooling to 40°C was performed over 40 minutes while the electric field was still applied, and then voltage application was terminated. The vibration body obtained from the above-described steps was brought into pressure contact with the contact body (slider) made of SUS420J2 by using a tension spring, and ten vibration-type actuators were produced.

**EP 4 645 672 A1**

(Example 2 to Example 10)

Ten vibration-type actuators were produced for each of Example 2 to Example 10 in a same manner as in Example 1, except that types of piezoelectric elements and types of elastic bodies to be bonded were those shown in Table 1.

(Comparative Example 1)

Ten vibration-type actuators were produced in Comparative Example 1 in a same manner as in Example 1, except that types of piezoelectric elements and types of elastic bodies to be bonded shown in Table 1 were used.
S1, S2 and S3 are calculated values obtained from W1, L1, R1 and R2 by calculation. W1, L1, R1 and R2 are measured values that were measured with an optical microscope.

[Table 1]

Table 1

| | Piezoelectric Material | | | |
|---|---|---|---|---|
| | Thickness t [mm] | Long Side L1 [mm] | Short Side W1 [mm] | S1 (L1*W1) [mm$^2$] |
| Example 1 | 0.40 | 8.90 | 5.7 | 50.73 |
| Example 2 | 0.40 | 8.80 | 5.7 | 50.16 |
| Example 3 | 0.40 | 8.80 | 5.50 | 48.40 |
| Example 4 | 0.40 | 8.70 | 5.60 | 48.72 |
| Example 5 | 0.40 | 8.70 | 5.60 | 48.72 |
| Example 6 | 0.35 | 8.90 | 5.70 | 50.73 |
| Example 7 | 0.30 | 9.10 | 5.64 | 51.32 |
| Example 8 | 0.30 | 9.10 | 5.59 | 50.87 |
| Example 9 | 0.30 | 8.90 | 5.70 | 50.73 |
| Example 10 | 0.25 | 8.90 | 5.50 | 48.95 |
| Comparative Example 1 | 0.40 | 8.90 | 5.70 | 50.73 |

Table 1 (continued)

| | Elastic Body | | | | Area Ratio | |
|---|---|---|---|---|---|---|
| | Outer Diameter of Protruding Portion R1 [mm] | Total Area of Outer Diameter of Protruding Portion S2 [mm$^2$] | Inner Diameter of Protruding Portion R2 [mm] | Total Area of Inner Diameter of Protruding Portion S3 [mm$^2$] | S2/S1 [mm$^2$] | S3/S1 [mm$^2$] |
| Example 1 | 1.80 | 5.09 | 1.50 | 3.53 | 0.100 | 0.070 |
| Example 2 | 1.90 | 5.67 | 1.60 | 4.02 | 0.113 | 0.080 |
| Example 3 | 1.90 | 5.67 | 1.60 | 4.02 | 0.117 | 0.083 |
| Example 4 | 2.10 | 6.93 | 1.70 | 4.54 | 0.142 | 0.093 |
| Example 5 | 2.20 | 7.60 | 2.00 | 6.28 | 0.156 | 0.129 |
| Example 6 | 1.80 | 5.09 | 1.50 | 3.53 | 0.100 | 0.070 |
| Example 7 | 1.80 | 5.09 | 1.50 | 3.53 | 0.099 | 0.069 |
| Example 8 | 1.80 | 5.09 | 1.50 | 3.53 | 0.100 | 0.069 |

(continued)

| | Elastic Body | | | | Area Ratio | |
|---|---|---|---|---|---|---|
| | Outer Diameter of Protruding Portion R1 [mm] | Total Area of Outer Diameter of Protruding Portion S2 [mm²] | Inner Diameter of Protruding Portion R2 [mm] | Total Area of Inner Diameter of Protruding Portion S3 [mm²] | S2/S1 [mm²] | S3/S1 [mm²] |
| Example 9 | 1.80 | 5.09 | 1.50 | 3.53 | 0.100 | 0.070 |
| Example 10 | 1.80 | 5.09 | 1.50 | 3.53 | 0.104 | 0.072 |
| Comparative Example 1 | 2.40 | 9.05 | 2.00 | 6.28 | 0.178 | 0.124 |

(Evaluation Method for Vibration-type Actuator)

A drive test was performed on the vibration-type actuator of each of the examples and the comparative example by applying an alternating voltage with an amplitude of 130 Vpp to the first electrode and the second electrodes. In the test, a phase difference between the voltages of the first electrode and the second electrode was set to -90° and 90°.

When the frequency of the alternating voltage is swept from a frequency higher than the resonance frequencies of Mode A and Mode B toward the resonance frequencies, the contact body is driven in a direction according to the phase difference between the alternating voltage, and stops after reaching the maximum speed. For convenience, the directions of travel when the phase difference is -90° and 90° are called the reverse direction and the forward direction, respectively. The maximum speed of the vibration body was measured by a sensor.

The value obtained by dividing the difference between the maximum speeds in the forward direction and the reverse direction by the maximum speed in the forward direction was defined as the round-trip speed difference, and a product whose round-trip speed difference is within ±20% was defined as a good product. In addition, the average of an absolute value of the round-trip speed difference was calculated. The result is shown in Table 2.

[Table 2]

Table 2

| | Good Product Rate | Average of Absolute Value of Round-Trip Speed Difference |
|---|---|---|
| Example 1 | 100% | 4% |
| Example 2 | 100% | 4% |
| Example 3 | 100% | 5% |
| Example 4 | 100% | 7% |
| Example 5 | 90% | 9% |
| Example 6 | 100% | 3% |
| Example 7 | 100% | 2% |
| Example 8 | 100% | 3% |
| Example 9 | 100% | 3% |
| Example 10 | 100% | 3% |
| Comparative Example 1 | 80% | 13% |

First, the good product rate of the vibration-type actuators produced in Examples 1 to 4 and Examples 6 to 10 was 100%.
A good product rate of the vibration-type actuators produced in Example 5 was 90%. The good product rate of the vibration-type actuator produced in Comparative Example 1 was 80%.

Since S2/S1 of the vibration-type actuators produced in Examples 1 to 10 was smaller than 0.178, the good product rate was 90% or more. On the other hand, since S2/S1 of the vibration-type actuators produced in Comparison Example 1 was 0.178, the good product rate was 80%.

It was confirmed that, by making S2/S1 smaller than 0.178 as in Examples 1 to 10, in-plane distribution of the piezoelectric properties due to the heating distribution within a plane of the piezoelectric element during polarization treatment could be reduced, and the good product rate was improved.

From results of the average absolute value of the round-trip speed difference in Examples 1 to 10, when S3/S1 is smaller, the in-plane distribution of the piezoelectric properties can be reduced, and a vibration-type actuator with a smaller average absolute value of the round-trip speed difference can be manufactured.

(Example 11)

The vibration-type actuator produced in Example 1 and an optical member were mechanically connected to each other to produce an optical device illustrated in FIG. 7. By controlling the alternating voltage applied to the piezoelectric material based on a position information provided to the encoder that includes the sensor and the scale, the vibration-type actuator and the optical member connected to the vibration-type actuator could be precisely driven to a target position. In the optical device, an optical lens was connected to the vibration-type actuator, and it was confirmed that the optical device has an automatic focusing function.

Although the above has been described using Manufacturing Composition 1 as an example, it was confirmed that, also in Manufacturing Compositions 2 to 46, vibration-type actuators with improved good product rates and driving characteristics could be manufactured as in Example 1 of the present disclosure.

As described above, by using an elastic body that includes protruding portions with small S2/S1 and S3/S1, the round-trip speed difference can be reduced, and vibration-type actuators in which the vibration characteristics in the forward direction and the reverse directions are equivalent can be stably provided.

[Table 3]

Table 3

| | x | y | a | Mn Concentration (Parts by Mass) | Bi Concentration (Parts by Mass) |
|---|---|---|---|---|---|
| Manufacturing Composition 1 | 0.140 | 0.080 | 0.9985 | 0.140 | 0.000 |
| Manufacturing Composition 2 | 0.020 | 0.020 | 1.0020 | 0.100 | 0.000 |
| Manufacturing Composition 3 | 0.095 | 0.060 | 1.0010 | 0.080 | 0.000 |
| Manufacturing Composition 4 | 0.125 | 0.090 | 1.0000 | 0.060 | 0.000 |
| Manufacturing Composition 5 | 0.095 | 0.030 | 1.0020 | 0.080 | 0.000 |
| Manufacturing Composition 6 | 0.095 | 0.095 | 0.9990 | 0.240 | 0.850 |
| Manufacturing Composition 7 | 0.110 | 0.075 | 0.9994 | 0.240 | 0.170 |
| Manufacturing Composition 8 | 0.110 | 0.075 | 0.9994 | 0.240 | 0.340 |
| Manufacturing Composition 9 | 0.110 | 0.075 | 0.9969 | 0.240 | 0.510 |
| Manufacturing Composition 10 | 0.110 | 0.075 | 0.9994 | 0.040 | 0.550 |
| Manufacturing Composition 11 | 0.120 | 0.080 | 0.9994 | 0.240 | 0.340 |
| Manufacturing Composition 12 | 0.125 | 0.020 | 1.0030 | 0.080 | 0.000 |
| Manufacturing Composition 13 | 0.125 | 0.050 | 1.0010 | 0.060 | 0.000 |
| Manufacturing Composition 14 | 0.130 | 0.075 | 0.9994 | 0.240 | 0.170 |
| Manufacturing Composition 15 | 0.140 | 0.075 | 1.0030 | 0.020 | 0.000 |
| Manufacturing Composition 16 | 0.140 | 0.075 | 1.0000 | 0.070 | 0.000 |
| Manufacturing Composition 17 | 0.140 | 0.075 | 1.0010 | 0.080 | 0.000 |
| Manufacturing Composition 18 | 0.140 | 0.078 | 0.9955 | 0.160 | 0.181 |
| Manufacturing Composition 19 | 0.140 | 0.075 | 1.0004 | 0.160 | 0.094 |

(continued)

|  | x | y | a | Mn Concentration (Parts by Mass) | Bi Concentration (Parts by Mass) |
|---|---|---|---|---|---|
| Manufacturing Composition 20 | 0.140 | 0.075 | 1.0004 | 0.160 | 0.189 |
| Manufacturing Composition 21 | 0.140 | 0.075 | 1.0004 | 0.160 | 0.239 |
| Manufacturing Composition 22 | 0.140 | 0.085 | 1.0004 | 0.160 | 0.539 |
| Manufacturing Composition 23 | 0.140 | 0.080 | 1.0004 | 0.140 | 0.289 |
| Manufacturing Composition 24 | 0.140 | 0.080 | 1.0004 | 0.140 | 0.339 |
| Manufacturing Composition 25 | 0.140 | 0.075 | 1.0004 | 0.160 | 0.094 |
| Manufacturing Composition 26 | 0.155 | 0.020 | 1.0050 | 0.150 | 0.000 |
| Manufacturing Composition 27 | 0.155 | 0.065 | 1.0000 | 0.020 | 0.000 |
| Manufacturing Composition 28 | 0.155 | 0.065 | 1.0010 | 0.060 | 0.000 |
| Manufacturing Composition 29 | 0.155 | 0.069 | 1.0040 | 0.180 | 0.000 |
| Manufacturing Composition 30 | 0.155 | 0.078 | 0.9994 | 0.240 | 0.170 |
| Manufacturing Composition 31 | 0.160 | 0.059 | 1.0090 | 0.400 | 0.000 |
| Manufacturing Composition 32 | 0.160 | 0.078 | 1.0042 | 0.360 | 0.170 |
| Manufacturing Composition 33 | 0.160 | 0.085 | 0.9971 | 0.180 | 0.170 |
| Manufacturing Composition 34 | 0.170 | 0.075 | 0.9998 | 0.140 | 0.189 |
| Manufacturing Composition 35 | 0.170 | 0.075 | 1.0042 | 0.360 | 0.170 |
| Manufacturing Composition 36 | 0.175 | 0.090 | 1.0070 | 0.100 | 0.000 |
| Manufacturing Composition 37 | 0.187 | 0.060 | 1.0090 | 0.240 | 0.000 |
| Manufacturing Composition 38 | 0.187 | 0.060 | 1.0100 | 0.400 | 0.000 |
| Manufacturing Composition 39 | 0.187 | 0.077 | 0.9994 | 0.240 | 0.170 |
| Manufacturing Composition 40 | 0.200 | 0.035 | 1.0060 | 0.200 | 0.000 |
| Manufacturing Composition 41 | 0.200 | 0.090 | 1.0060 | 0.260 | 0.000 |
| Manufacturing Composition 42 | 0.200 | 0.075 | 0.9994 | 0.240 | 0.170 |
| Manufacturing Composition 43 | 0.220 | 0.082 | 0.9994 | 0.240 | 0.170 |
| Manufacturing Composition 44 | 0.220 | 0.030 | 1.0050 | 0.220 | 0.000 |
| Manufacturing Composition 45 | 0.260 | 0.070 | 1.0050 | 0.280 | 0.000 |
| Manufacturing Composition 46 | 0.300 | 0.095 | 1.0080 | 0.300 | 0.000 |

[Industrial applicability]

The vibration-type actuator of the present disclosure can be preferably utilized as a driving unit of an optical device. In addition, the vibration-type actuator of the present disclosure can also be widely utilized as a driving unit of an electronic device.

According to the present disclosure, vibration-type actuators in which the vibration characteristics in the forward direction and the reverse directions are equivalent can be stably provided. As a result, a yield of vibration-type actuators can be further improved.

While the present disclosure has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

**Claims**

1. A vibration-type actuator comprising:

a vibration body that includes a rectangular-shaped elastic body and a piezoelectric element including a piezoelectric material and an electrode; and
a contact body that contacts the elastic body,
the vibration body and the contact body being relatively moved by vibration of the vibration body,
wherein a content of lead included in the piezoelectric material is 1000 ppm or less,
the elastic body includes at least one protruding portion and a flat portion, the at least one protruding portion including a top portion that contacts the contact body,
the at least one protruding portion is provided with a space portion therein, and includes an outer surface and an inner surface,
the top portion is arranged at a position crossing a nodal line of out-of-plane vibration of the elastic body in plan view, and
a value obtained by dividing a total area of a portion surrounded by the outer surface when a base portion of the at least one protruding portion is viewed in cross section in a direction parallel to the flat portion by a product of a length of a short side and a length of a long side of a principal surface of the piezoelectric element is smaller than 0.178.

2. The vibration-type actuator according to claim 1, wherein the at least one protruding portion comprises two protruding portions, and a value obtained by dividing a total area of portions surrounded by respective outer surfaces when base portions of the two protruding portions are viewed in cross section in the direction parallel to the flat portion by the product of the length of the short side and the length of the long side of the principal surface of the piezoelectric element is smaller than 0.178.

3. The vibration-type actuator according to claim 2, wherein respective top portions of the two protruding portions are arranged to cross nodal lines of out-of-plane vibration of the elastic body, so that a distance between the two protruding portions becomes shortest.

4. The vibration-type actuator according to claim 1 or 2, wherein the at least one protruding portion comprises two protruding portions, and a value obtained by dividing a total area of portions surrounded by respective inner surfaces when base portions of the two protruding portions are viewed in cross section in the direction parallel to the flat portion by the product of the length of the short side and the length of the long side of the principal surface of the piezoelectric element is smaller than 0.124.

5. The vibration-type actuator according to any one of claims 1 to 4, wherein the elastic body includes supporting portions that protrude from end portions of the flat portion.

6. The vibration-type actuator according to any one of claims 1 to 5, wherein the piezoelectric element has a thickness of 0.25 to 0.40 mm.

7. The vibration-type actuator according to any one of claims 1 to 6, wherein the piezoelectric material includes a barium titanate-based material.

8. The vibration-type actuator according to any one of claims 1 to 7, wherein the piezoelectric material includes barium calcium titanate zirconate.

9. The vibration-type actuator according to any one of claims 1 to 8, wherein the piezoelectric material is a piezoelectric material containing an oxide and Mn, the oxide having a perovskite-type structure including Ba, Ca, Ti and Zr,

$x$, which is a ratio of a molar amount of the Ca to a sum of a molar amount of the Ba and the molar amount of the Ca, is $0.02 \leq x \leq 0.30$,
$y$, which is a ratio of a molar amount of the Zr to a sum of a molar amount of the Ti and the molar amount of the Zr, is $0.020 \leq y \leq 0.095$ and $y \leq x$,
$\alpha$, which is a ratio of a sum of the molar amount of the Ba and the molar amount of the Ca to a sum of the molar amount of the Ti and the molar amount of the Zr, is $0.9955 \leq \alpha \leq 1.01$, and
a content of the Mn with respect to 100 parts by mass of the oxide is 0.02 parts by mass or more and 1.0 parts by mass or less in terms of metal.

10. The vibration-type actuator according to any one of claims 1 to 9, wherein a depolarization temperature Td of the piezoelectric material is 126°C or less.

11. The vibration-type actuator according to any one of claims 1 to 10, wherein the elastic body is martensitic stainless steel.

12. A manufacturing method of a vibration-type actuator including a vibration body with high vibration symmetry, the manufacturing method comprising:

providing electrodes to a piezoelectric material that has not been subjected to polarization treatment to obtain a piezoelectric element;
bonding the piezoelectric element and an elastic body at a temperature T1;
bonding the piezoelectric element and a power supply member at a temperature T2;
performing polarization treatment on the piezoelectric material at a temperature T3 to produce a vibration body; and
bringing the vibration body into pressure contact with a contact body, in this order,
wherein the elastic body includes a protruding portion and a flat portion, the protruding portion including a top portion,
the protruding portion is provided with a space portion therein, and includes an outer surface and an inner surface,
a value obtained by dividing a total area of a portion surrounded by the outer surface when a base portion of the protruding portion is viewed in cross section in a direction parallel to the flat portion by a product of a length of a short side and a length of a long side of a principal surface of the piezoelectric element is smaller than 0.178, and
T1, T2 and T3 satisfy relationships T1 > T3 and T2 > T3.

13. The manufacturing method of the vibration-type actuator according to claim 12, wherein T1, T2, and T3 satisfy a relationship T1>T2>T3.

14. An electronic device comprising:

a housing; and
the vibration-type actuator according to any one of claims 1 to 11.

15. An optical device comprising:

an optical element or an imaging element;
a housing; and
the vibration-type actuator according to any one of claims 1 to 11.

FIG. 1A

103  106                    106

102

110

FIG. 1B

104

100

103
108

120
122
121

FIG. 1C

109          102

107

108

101a      101b

101

# FIG. 2A

MODE A

# FIG. 2B

MODE B

# FIG. 3

# FIG. 4A

```
--------  MODE A VIBRATION NODAL LINE
— · — · — · —  MODE A VIBRATION ANTINODAL LINE
```

# FIG. 4B

```
--------  MODE B VIBRATION NODAL LINE
— · — · — · —  MODE B VIBRATION ANTINODAL LINE
```

# FIG. 5

FIG. 6A

FIG. 6B

FIG. 6C

# FIG. 7

Europäisches
Patentamt
European
Patent Office
Office européen
des brevets

# EUROPEAN SEARCH REPORT

**Application Number**

EP 25 17 3572

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2019/334458 A1 (FURUTA TATSUO [JP] ET AL) 31 October 2019 (2019-10-31) <br> * figures 1-7 * <br> * paragraph [0075] - paragraph [0106] * <br> * paragraph [0124] - paragraph [0140] * <br> * paragraph [0192] - paragraph [0193] * <br> ----- | 1-15 | INV. <br> H02N2/02 <br> H10N30/073 <br> H10N30/853 <br> G02B7/00 <br> G03B3/10 |
| Y | US 2023/060963 A1 (SHIMADA AKIRA [JP]) 2 March 2023 (2023-03-02) <br> * figures 3-5 * <br> * paragraph [0047] - paragraph [0057] * <br> ----- | 1-15 | |
| A | US 2018/316284 A1 (UEDA MIKI [JP] ET AL) 1 November 2018 (2018-11-01) <br> * figures 1-9 * <br> * paragraph [0054] * <br> ----- | 1-15 | |
|  |  |  | **TECHNICAL FIELDS SEARCHED (IPC)** <br><br> H02N <br> H10N <br> G02B <br> G03B |

The present search report has been drawn up for all claims

| Place of search | Date of completion of the search | Examiner |
|---|---|---|
| Munich | 15 September 2025 | Krohns, Stephan |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P4C01)

## ANNEX TO THE EUROPEAN SEARCH REPORT
## ON EUROPEAN PATENT APPLICATION NO.

EP 25 17 3572

This annex lists the patent family members relating to the patent documents cited in the above-mentioned European search report.
The members are as contained in the European Patent Office EDP file on
The European Patent Office is in no way liable for these particulars which are merely given for the purpose of information.

15-09-2025

| Patent document cited in search report | | Publication date | Patent family member(s) | | Publication date |
|---|---|---|---|---|---|
| US 2019334458 | A1 | 31-10-2019 | CN | 110114968 A | 09-08-2019 |
| | | | CN | 114123847 A | 01-03-2022 |
| | | | EP | 3556005 A1 | 23-10-2019 |
| | | | JP | 7302059 B2 | 03-07-2023 |
| | | | JP | 2018107437 A | 05-07-2018 |
| | | | JP | 2022087120 A | 09-06-2022 |
| | | | TW | 201824595 A | 01-07-2018 |
| | | | US | 2019334458 A1 | 31-10-2019 |
| | | | WO | 2018123819 A1 | 05-07-2018 |
| US 2023060963 | A1 | 02-03-2023 | JP | 7527828 B2 | 05-08-2024 |
| | | | JP | 2021168580 A | 21-10-2021 |
| | | | US | 2023060963 A1 | 02-03-2023 |
| | | | WO | 2021210366 A1 | 21-10-2021 |
| US 2018316284 | A1 | 01-11-2018 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017184233 A

- JP 2011200051 A